# EUROPEAN PATENT SPECIFICATION

(11) **EP 1 921 655 B1**
(45) Date of publication and mention of the grant of the patent: **31.03.2010**
(21) Application number: 06123896.0
(22) Date of filing: 10.11.2006
(51) Int. Cl.: H01J 37/32

(54) **Plasma source with plurality of out of phase electrodes**
Plasmaquelle mit Vielzahl phasenversetzter Elektroden
Source à plasma avec une pluralité d'électrodes déphasées

(43) Date of publication of application: 14.05.2008
(73) Proprietor: Dublin City University, Dublin 9 (IE)
(72) Inventor: Ellingboe, Albert Rogers, Co. Dublin (IE)
(74) Representative: Moore, Barry

(56) References cited:
- WO-A-01/12350
- WO-A-97/02589
- WO-A-98/32154
- WO-A-03/017318
- WO-A-2006/120239

## Description

### Field of the Invention

The present invention relates to plasma sources and in particular to a plasma source with reactive elements configured to be out of phase with one another so as to provide for controlled wavelength effects within the plasma process.

### Background

A plasma is an ionised gas that conducts electricity. In order to generate a plasma, an electrical field is applied to a contained gas, usually contained within a specifically designed chamber. In a vacuum chamber, where ions and electrons have long lifetimes, it is relatively easy to do this. Radio frequency (RF) power in the MHz range can be applied to two metal plates, or electrodes, immersed in the chamber, thereby creating a capacitive discharge.
Alternatively, RF power may be deposited into a coil mounted on the chamber walls, thereby producing an inductively coupled plasma.

In the semiconductor industry, plasmas are used to deposit materials on and etch materials from workpieces that are typically semiconductor, dielectric and metal surfaces. This process is utilised so as to form specific electronic components on the substrate. A gas is introduced into a vacuum plasma processing chamber where the workpiece is located. The gas by undergoing an electrical breakdown forms a plasma in an excitation region using either an inductive source, where the antenna carries a current adjacent to the plasma window or a capacitive source which uses one (or more) electrode(s) with an oscillating voltage. Up until the early 1990's capacitive based systems were the preferred option but in the time period 1991 to 1995, inductive sources became more prevalent, and they continue to dominate in metal etch or poly etch applications. There are however problems with such inductive source plasmas in oxide etch applications. Furthermore, designs of inductive systems for oxide etch that provide the necessary performance and stability for manufacturing criteria results in the cost of an inductive based system being quite high.

Around 1998 the manufacturers of these systems, companies such as Lam Research Corporation and TEL started to refocus on capacitive systems so as to provide a cheaper and more reliable solution to the problems of plasma etching in this field. Further developments led to the reintroduction of capacitive systems at the expense of inductive systems. It is into this environment that dual frequency capacitive systems re-emerged as the preferred choice for oxide etch applications.

The reason for this trend towards dual frequency systems is that in a single frequency capacitive reactor, it is possible to increase the RF power to get higher ion bombardment energy, but the plasma density will also increase. These two parameters cannot be changed independently using a single frequency generator. In order to provide an additional degree of flexibility, more than one frequency of excitation of a capacitive plasma can be provided. A typical approach, such as that described in WO03015123, employs two separate power supplies (a high frequency supply and a low frequency supply), each attached to one electrode. Filtering is employed to minimize the interaction between the two signals, for example using an inductor that grounds the top electrode at a KHz signal, while appearing to be a high impedance for a MHz signal. Similarly, a capacitor is used to ground the lower electrode for high frequency signals. Alternative configurations include triode or confined arrangements where the plasma is confined within a specific radial geometry and a further arrangement where both supplies are connected to the same electrode can also be employed. In all cases the substrate, and therefore necessarily the associated substrate handling components such as pins and lifters, coolants, sensors etc., are RF driven so coupling to the outside world needs to be sympathetic to those environments. This results in added engineering complexity- adding inevitably to cost.

To a fair approximation, in a dual frequency capacitive system the high frequency power controls the plasma density; due to the higher currents more efficient displacement current increasing the ohmic power into the plasma and sheath heating mechanisms. The low frequency excitation influences the ion bombardment energy. Therefore, the user has some ability to separately adjust the ion bombardment energy and the plasma density, which is not very easy with a single excitation frequency. Reactors of this design have found applications in both PECVD (plasma enhanced chemical vapor deposition) and plasma etching.

WO98/32154 discloses a plasma reactor comprising a plasma excitation region in between a grounded reference electrode and a plasma exciting reactive impedance element. The latter is subdivided into alternating electrode elements of parallel sub-electrode bars. The electrode elements are driven by RF voltages V₁₁ and V₁₂, which, in some embodiments, are out of phase by 180° and may be modulated.

Most known systems use a single electrode through which power may be introduced to the plasma region. US2004/0168770, US6,962,664 and US6,884,635 all assigned to Tokyo Electron Limited (TEL) describe the use of a segmented electrode structure that has a plurality of electrode segments, each segment having a RF power supplies coupled thereto. A control system is configured to dynamically change impedances to match the plasma load impedance. These arrangements are specifically arranged to minimize any interaction between electrodes thereby implying that the electrode elements are in phase with one another. In all cases however there is still a net current introduced into the plasma which at high operational frequencies can cause wavelength effects in the electromagnetic power distribution, resulting in non-uniform voltages and currents, and non-uniform power deposition into the plasma, and resultant non-uniform processes (etching and/or deposition) on the substrate surface.

Despite these advances in reactor design a number of problems still exist. These include the mentioned wavelength effects which cause voltage non-uniformities and introduce currents in the plasma parallel to the electrode surfaces, and under these conditions there is also non-uniform power deposition, which may be expected to produce non-uniform plasma density which degrades the performance of the plasma.

There is therefore a need to provide a plasma source which is configured to overcome these and other problems.

### Summary

These and other problems are addressed by a plasma source in accordance with the invention. Such a source, provides a plurality of adjacent electrodes, each electrode being out of phase relative to its adjacent neighbour.

The electrodes can be configured in any one of a plurality of different geometrical configurations including for example planar, hemispheric, dome, convex, concave and/or undulating. The electrodes could be provided so as to be in direct contact with the generated plasma. Using an arrangement in accordance with the present invention it is possible to control the relative centre to edge power deposition by modifying electrode spacings and/or power distribution design and/or the inclusion of active elements such as capacitors and/or inductors.

The invention therefore provides a plasma source according to claim 1 with advantageous embodiments being detailed in the dependent claims. The invention also provides a plasma source substantially as hereinafter described with reference to the following drawings.

These and other features of the invention will now be described with reference to exemplary embodiments of the invention.

### Brief Description Of The Drawings

Figure 1 is a schematic showing a plasma source.
Figure 2 is a modification to the system of Figure 1 showing an alternative coupling arrangement for the LF power supply.
Figure 3 shows, in schematic form, an arrangement for using a plasma source with a roll of film.
Figure 4 is an example of an electrode arrangement that can be used in a tri-phase powering arrangement.
Figure 5 shows a typical arrangement for the phase differences between three supplies for use with the electrode arrangement of Figure 4.
Figure 6 shows an alternative pumping arrangement for introducing and pumping of gas in the plasma chamber.
Figure 7 shows an example of a switching sequence for use in operation of a source.
Figure 8 is a schematic of a re-entrant probe.
Figure 9 is an example of the type of circuit that may be used to use switches to provide the high-frequency power in conjunction with coupling a LF generator to two or more of the electrodes.

### Detailed Description of the Drawings

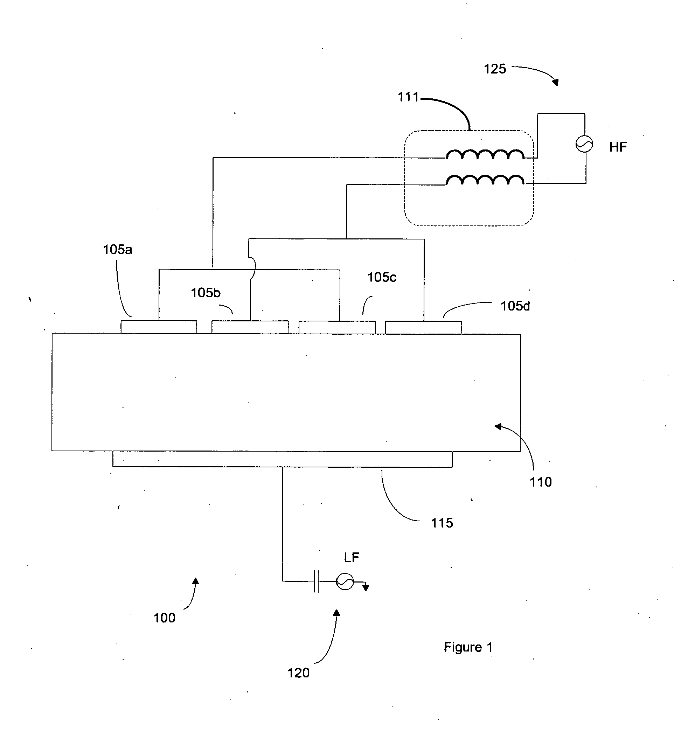

Figure 1 shows a schematic of operational components of a plasma source 100 . The source 100 includes a plasma excitation region 110 provided within a chamber body, into which a process gas may be introduced. This region defines the ultimate plasma volume and it is within this region that the gas is converted into a plasma, which is then used to process workpieces placed within the region. A plasma exciting reactive impendence element 105 is provided above the excitation region 110. This element is coupled to a high frequency (HF) generator or source 125, the application of which to the element being used to control density of the plasma. Within the present description the term high frequency is intended to encompass electromagnetic radiation provided in the range 10MHz - 300 GHz, which sometimes would be referred to as frequency in the radio-frequency to ultra-high frequency range. A reference electrode 115 is displaced below the region 110 and is optionally coupled to a low frequency (LF) source, the application of which is used to control the energy of the ions striking the surface (as per present state-of-the-art). Typical values for a low frequency generator for use with a source of the present invention is one that gives an output in the range 75-460 kHz - exemplary generators include those supplied build by ENI and RFPP and Advanced Energy. Within the context of the present invention a low frequency source is one that dominantly drives ion energy and results in a capacitive voltages on the sheaths. Where the low source is operable in combination with the high frequency source it is desirable to be able to differentiate between the two and therefore an order of magnitude separation between the frequency of operation of the low frequency and the high frequency is sufficient. The LF is intended to have sufficiently lower plasma current such that the ohmic power deposition - |Λ2R - is small in comparison to the HF power. Then, the LF contribution is dominately in the voltage on the electrodes. It will be appreciated that certain applications may desirably provide for two or more LF section in series, for example one at 13.56 MHz, the other at something like 300-800 kHz.

The reference electrode provides a mount for the workpiece (not shown), which is typically a semiconductor, dielectric or metal substrate. The application of suitable fields to the elements 105, 115 serves to generate and maintain the correct ratio of ions and radicals relative to neutral species in the plasma and a control of the energy of the ions incident on the workpiece; gas transport and the residence time of these particles in the excitation region play an important role. This control is required to ensure a correct methodology for the selected deposition or etch processes being employed.

The reactive element is fabricated from a plurality of individual electrodes which are all arranged on the same side of the plasma excitation region. In this example, four individual electrodes 105a, 105b, 105c, 105d are provided, the four electrodes combining to form two sets of electrodes 105a/105c and 105b/105d. Desirably, an even number of electrodes are provided and each of the electrodes is individually coupled to the high frequency power supply which is configured to provide a differential signal to adjacent or neighbouring electrodes, i.e. those electrodes located beside each other and on the same side of the plasma excitation region. In this manner the signal applied to a first electrode 105a is out of phase with the signal applied to its immediate neighbour 105b. Similarly electrode 105b is out of phase with electrode 105c and electrode 105c is out of phase with electrode 105d. In this way it can be considered that the high frequency generator or drive creates a differential between sets of electrodes. By the very nature of inductive coupling, wavelength effects will be present in the electrodes and the plasma but the multiple electrodes that make up the reactive element of the present invention are advantageous in that the wavelengths effects can be controlled so as to yield the desired plasma density as opposed to the traditional single electrode problem of non-uniform effects. The dimensions of the individual electrodes are chosen and optimized such that non-uniformities on the scale-length of the electrode size that occur adjacent to the reactive elements do not result in excessive plasma non-uniformity at the substrate. It will be appreciated that these dimensions may vary depending on the specific application for which the plasma source is used but desirably the size of each of the individual electrodes is less than or equal to the distance between the source and the substrate or workpiece and is such as to provide uniform effects, if so desired for the particular application. A transformer 111 may optionally also be included if there is a requirement for the equalisation of currents.

The plurality of electrodes provided by the source enables a control of the net current induced into the plasma volume. It will be appreciated that at high frequencies any net current introduced into the plasma volume may be reflected through wavelength effects into voltage asymmetries on the surface of the workpiece. This is not advantageous. Through effective coupling of currents into neighbouring segments it is possible to reduce the sum of the net current introduced into the plasma volume so as to obviate these wavelength effects at the workpiece. In an array architecture, where a plurality of segments are divided into sets of similarly configured in-phase electrodes, each of the sets may introduce a net current into the volume, but the combination or sum of the net currents introduced will be reduced by substantially cancelling each other. Such cancelling is achieved by driving different sets out of phase with one another, the net effect being that any phase effects introduced by one electrode set are cancelled by that of another.

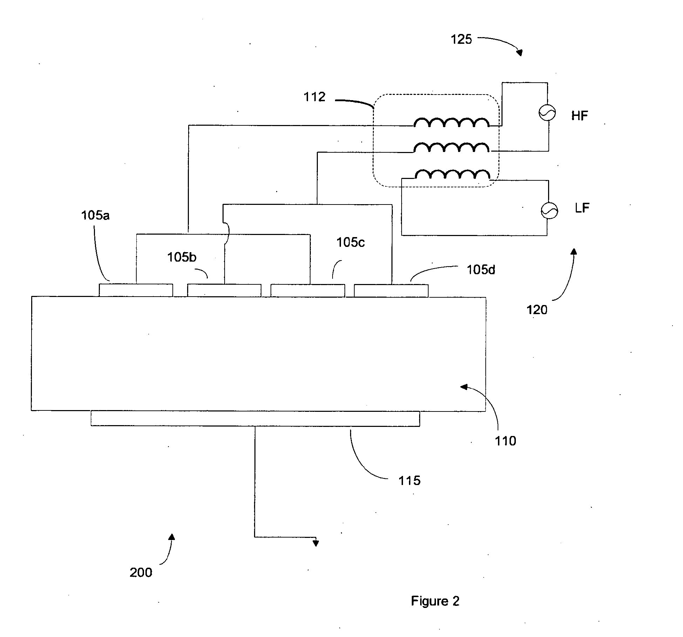

Figure 2 shows a plasma source 200 which is a modification to the arrangement of Figure 1 where both the LF and HF supplies are coupled to the reactive element. In this embodiment, the HF generator and the LF generator may be applied simultaneously or independently of one another. By coupling both generators to the same reactive element plate it is possible for the lower electrode, the reference electrode, to be grounded. It is not necessary to provide a capacitor in this path to ground (i.e. the reference electrode can be directly coupled to ground), and this arrangement of enabling the reference electrode to be grounded is highly advantageous in that the engineering requirements for the chamber are simplified. For example, in arrangements where a moveable bottom stage was provided it was traditionally necessary for the bellows that make up that moveable stage to define an unknown and variable impedance path; with the grounding of this lower stage, this is no longer a requirement. In accordance with the teaching of the invention the high frequency generated by the high frequency generator and coupled to the reactive elements can be isolated from the rest of the chamber. This is particularly advantageous in such scenarios of changing the volume of the plasma excitation region. There are many possible design arrangements that may be used to allow for a changing in the size of the plasma volume such as having one (or both) electrode mounted on a bellows, allowing for variation in the gap between the electrodes, the provision of sliding o-ring seals, nested cylinders, etc, have been used in the industry. However, in all cases, by operating the HF in differential mode, with LF in common mode, there is no HF in the ground-return path, and the LF is able to control the voltage between the plasma and the substrate, and thereby the ion energy. The frequency of the LF can be chosen such that there are no wavelength effects that affect the process uniformity. The LF is comparably simple to accommodate for the current the return-path. Thus, having the HF in differential mode and LF in common-mode simplifies the design and operation of a system with variable-gap.

It will be appreciated that using techniques known in the art that the effect of the LF output can be maximised in the region of interest by confining the plasma volume. This can be achieved in a variety of ways such as for example quartz confinement rings.

The LF supply can be provided in either a differential or a common mode. In a differential mode, with the low frequency signal applied to a first electrode being out of phase with that provided to its immediate neighbour, the ion energy is provided on the reactive element electrodes or on a dielectric material coupled thereto. If the LF supply is provided in a common mode, then greater ion energy is provided on the reference electrode, and a net current is introduced into the plasma volume. This driving of the plurality of electrodes making up the reactive element in a common mode configuration therefore controls the ion bombardment onto the workpiece that is mounted on the reference electrode. It will be understood that differential mode results in lower ion energy to the substrate (reference electrode) but maintains high ion energy to reactive elements for sputtering material and/or keeping electrodes clean from deposition. Similarly to that described with reference to Figure 1, a transformer 112 may optionally be provided for coupling LF either in common mode or differential mode. Furthermore, the illustrated methodology used for providing LF will be appreciated as being exemplary of the type of methodology that could be implemented as it will be appreciated that other techniques such as for example, low pass filters or LF match-box components connecting LF power to the HF lines, could be used to couple LF power into the system.

As mentioned above, with the addition of the low frequency applied to the reactive elements of the segmented upper electrode in common-mode, the substrate and reference electrode can be grounded. This allows for the back-side of the reference electrode, ie that side away from the plasma excitation region, to be an environment where there is no RF fields. The back-side of the reference electrode, supporting the processed substrate, includes many complex, delicate, and detailed support services which improve the quality of the processed surface. These 'support services' include a number of arrangements for example the mechanism for lifting the substrate off of the reference electrode for the purposes of transport (lift-pins), electrostatic chuck for holding the substrate onto the reference electrode, power for operating heating elements in the reference electrode, coolant loops for removing excess heat from the reference electrode, thermocouples for measuring the temperature of the wafer and/or reference electrode, provision of current/voltage for the operation of the electrostatic chucking are simplified as the power supplies do not need to be floating to accommodate dc-bias on the substrate surface but are ground referenced.

Having the support services in an area without RF fields reduces the cost, and reduces the complexity of design, install and maintenance of the support services. In addition, other diagnostics based on the measurement of RF and DC currents into the reference electrode surface and by contact to the back-side of the substrate. Such measurements could be used for measurement of local voltages and currents for the optimization of process.

It will be understood that by operating the high frequency source in a differential mode, that there is substantially no high frequency current introduced into the reference electrode, and furthermore that there is no high frequency current in the chamber walls. This addresses the problems of having to scale the size of the electrode to the wavelength of the imposed high frequency power. The size of the electrode does not have to be much smaller than a ¼ wavelength of the imposed HF power to obviate the possibility of voltage non- uniformities being introduced along the surface of the electrode. This is true for both for the 'plasma source' side of the source and the substrateholder (reference electrode) side of the source. The use of a segmented source electrode with HF power operated in differential mode, results in near zero net HF current into the plasma. This, in turn, means there is near zero HF current in the sheath above the substrate and into the reference electrode. When there is net HF current, then there will be voltage non-uniformities on large, unsegmented electrodes, such as the reference electrode supporting the workpiece. Furthermore, when there is net HF current, then there is HF current flowing through the chamber walls back to the HF current source. Controlling the current path for the return current is critical for consistent operation of a plasma source, and in particular for consistent operation between multiple systems as would occur in manufacturing environments.

Such cancelling of the net current introduced into the volume allows the operation of the high frequency source at frequencies greater than heretofore possible, specifically at frequencies where traditionally wavelength effects would have been noticeable or problematic. The frequency at which wavelength effects becomes apparent will vary depending on the surface area of the substrate being processed. For example 300mm substrates may experience wavelength effects at frequencies in excess of 48 MHz whereas 550mm substrates will be affected at frequencies at about 27MHz. There is an inverse relationship between the area of the substrate being processed and the frequency at which the wavelength effects would traditionally become noticeable. For processing of wafers or other substrates where the wafers are becoming larger and larger, it will be appreciated that the frequencies will drop. It can be considered therefore that 20MHz is an appropriate figure to consider as a lower boundary for wavelength effects and yet there is a desire in operation of plasma sources to drive the high frequency generator in excess of that frequency and even more so in excess of 50 MHz. Therefore the operational frequencies of the high frequency source may be considered in the range 15MHz to 299GHz optionally in the range 20 MHz to 250 GHz, and further optionally in the range 25 MHz to 150 GHz.

Operating the high frequency source in a differential mode serves to confine the generated high frequency to the reactive elements of the segmented upper electrode, and to isolate the substrate or reference electrode, and chamber body from the HF current. It is possible to therefore achieve ion bombardment of the substrate using the low frequency generator, operate the high frequency generator in excess of frequencies where wavelength effects could be considered normally to become a problem and yet have no such effects introduced.

The generators or supplies can be operated in either VHF or RF modes, with the difference being that in VHF mode the high frequency will couple inductively whereas in RF mode, it will be coupled capacitively. The ability to change frequency enables one to control the transfer from an inductive discharge to a capacitive discharge, so that one can go from high to low frequencies and vice versa without resultant non-uniform etch (or whatever surface treatment is being provided using the plasma treatment) profiles resulting on the workpiece, as would happen if a single electrode were utilised as in the prior art arrangements. Although the actual frequency at which the inductive discharge becomes predominant is not exact, it is thought that at frequencies of about 500MHz, that the plasma discharge is predominately inductively based.

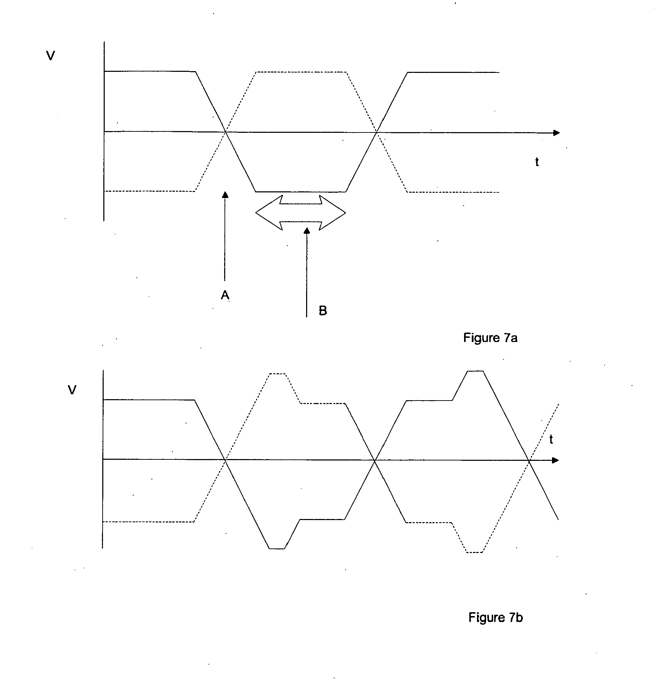

In a modification to that described heretofore, the HF source may also operate in a switch mode as opposed to a sinusoidal operation. Such a switch mode operation is advantageous in that it is possible to alter the slew-rate of the switch region so as to yield an "effective frequency" which will determine amount of inductive coupling. The length of time the reactive element is left in the high voltage state, i.e. a plateau region, would control the ion bombardment energy of the upper electrode- and if the source is used in a confined arrangement, the lower electrode. The choice of the value of the high voltages is useful in that it controls ion impact energy and assists in keeping the upper electrode clean. Control of the period between ramp ups, i.e. between switching, gives you control over the power deposited into the volume. Switch mode generators are very well known in the general electronics field with well defined characteristics and components. The ability to use such a switch mode generator provides for a reduction in cost of the plasma source- switch mode generators are cheaper than the equivalent sinusoidal based generator. By controlling the slew rate one is able to move easily from the RF range to Ultra High Frequencies (UHF) thereby providing the possibility to tune the process chemistry and/or the electron temperature, Tₑ. An example of the type of switch mode operation is shown in Figure 7 where it is shown on Figure 7a that a planar plateau region may be provided having relatively constant high or low voltage signals whereas in Figure 7b, a multi step arrangement is provided. The switch region is marked as "A" and the plateau region is "B". The "A" region may also be considered as an overshoot caused by reactive elements between the voltage switch and the electrode which can be designed for and controlled.

Figure 9 shows an example of the type of circuit configuration that may be used in providing such a switch mode operation. In this arrangement a LF generator 900, a negative supply 905 and a positive supply 910 are all switchably coupled via one or more field effect transistors (FETs) 920 or some other switching elements to one or more of the electrodes 925. It is optimum that any switch used is a high speed switch. The electrodes can be individually coupled to the respective supplies or can be grouped in sets of electrodes which will all be switched at the same time. A FET driver element 930 is coupled to the FETs to control the switching and the selected ones of the electrodes to be switched is determined by a control line 935. In the embodiment illustrated in Figure 9, the control line is coupled, (in a similar fashion to the LF supply, the positive supply and the negative supply) via a coil of a transformer 940 to the FET driver. In another embodiment, where for example the control line is provided as an optical feed, it may be coupled directly to the FET driver.

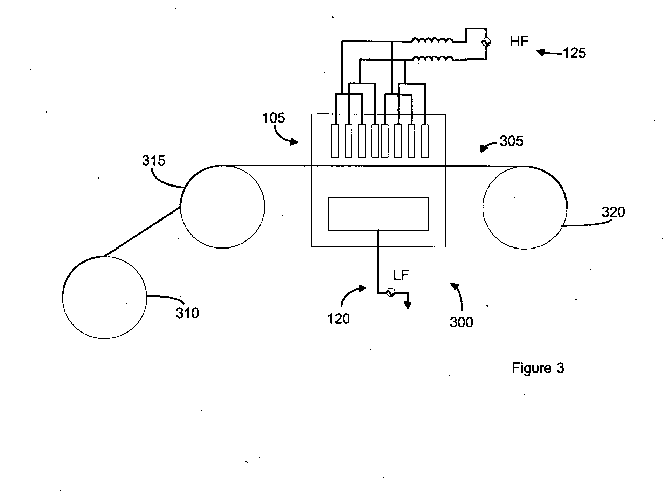

Heretofore, the plasma source has been described with reference to a plasma source configured to operate with a planar workpiece, where the electrodes making up the reactive impedance element and the reference electrodes are substantially parallel to each other and to the workpiece. Such arrangements are advantageous and useful for application in the semiconductor environment where a planar wafer is provided for etching. However it is known that plasma sources can also be used in other applications where it is desired to process a non-planar substrate, for example a roll of film in a textile screen printing application. Figure 3 shows in schematic form how the plasma source can be configured for use in such an arrangement 300 where a roll of film 305 is originally provided on a reel 310. The film is unwound from the initial reel 310 on an unwind station 315, passes through the plasma source 105 where it is processed and is re-wound on a rewind station 320. The plasma source of the present invention is suitable for processing such large dimension surfaces because the multiple electrodes that make up the reactive element enable the provision of uniform plasma over an extended area. The arrangement of the plasma source allows for the provision of higher frequency sources to be used and therefore the speed of the film through the plasma source can be increased. These higher frequencies do not lead to a detraction in the quality of the plasma as the multiple electrodes of the reactive element provide for higher density application without detracting from the uniformity of the applied plasma. It will be appreciated that such an arrangement may also be modified for plasma screens, LCD displays, industrial coating on metal/glass, and the like where simultaneous processing of large areas is required. Although the LF supply shown in this embodiment is coupled to the substrate plate it will be understood that in a manner similar to that described with reference to Figure 2 that one could also have a low frequency feed through the upper reactive elements. A feature of the plasma source is that the source can also be extended in the direction of travel of the material. Thus the amount of plasma treatment of the surface (etching, deposition, modification of surface properties, etc.) can be controlled by the physical extent of the plasma source. This further enables the integration of multiple processing steps where the amount of processing being done by the different steps may be individually optimized. For example if the material being processed has a velocity of 1 m/min and passes through two sequential plasma source areas with physical length of 25 and 50 cm, the active processing time for the two sources would be 15 and 30 seconds, respectively. In this way an electrode arrangement may be provided in two dimensions with the second dimension enabling a movement of the substrate through the reaction volume, enabling a continuous processing of a web as it travels through the source.

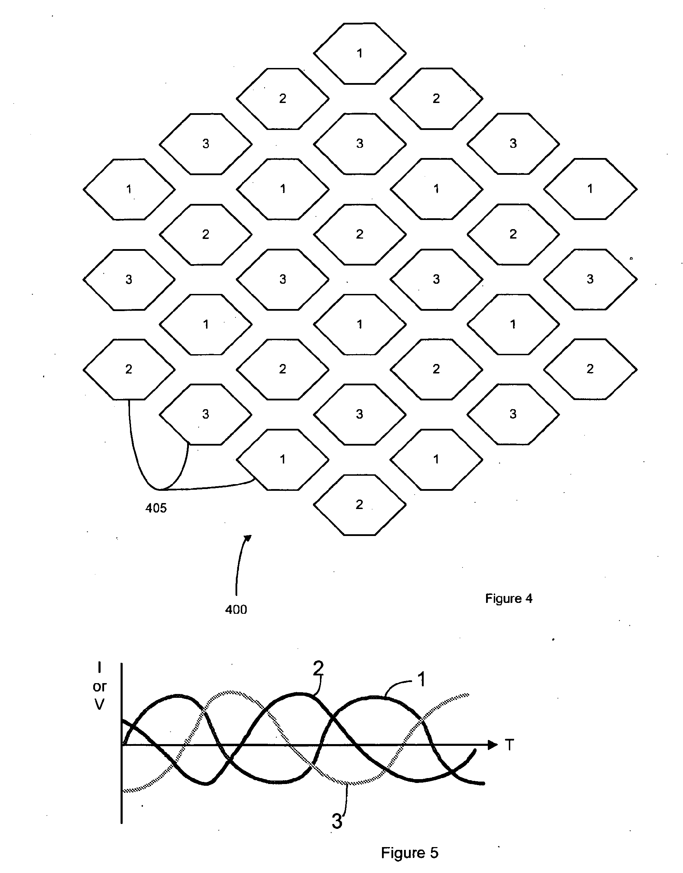

Certain applications may require the use of a curved processing area. The plasma source provides for such processing in one of two ways. In the first, in a manner similar to that described with reference to Figure 3, it utilises a substantially planar arrangement of reactive elements to process a curved workpiece. Figure 4 shows an alternative arrangement where the source could be applied to non-planar plasma volumes. In this example it may be advantageous to provide an electrode configuration that can be configured in a non-planar configuration-either by arranging planar electrodes in a non-planar geometry or providing non-planar electrodes. The example of Figure 4 shows the former arrangement where a plurality of planar electrodes are arranged in a hexagonal close pack configuration 400 including a plurality of individual hexagonally dimensioned electrodes 405. In this example, a 3 phase drive mechanism is used as opposed to the direct push pull operation of the configuration of Figures 1 to 3, and each of the individual electrodes is coupled to a respective one of the three sources (identified by the labelling 1, 2, 3 respectively). As with the embodiment of the previous Figures, no two adjacent electrodes are in phase with one another- see Figure 5 for an example of the output configuration for each of the sources. To assist in current balance a tri-filar transformer may be used which is advantageous in that it allows for the provision of a low voltage above the substrate and an equalisation of the currents. In other circumstance, it will be appreciated that certain applications where it is useful to drive a net current and therefore a net voltage intro the reference electrode may find it advantageous to have an element of current imbalance. It will be further appreciated that the examples of two and three phase sources are exemplary of the type of frequency generator that could be used with the reactive elements of the plasma source and that certain other applications may require sources capable of providing a higher order phase supply.

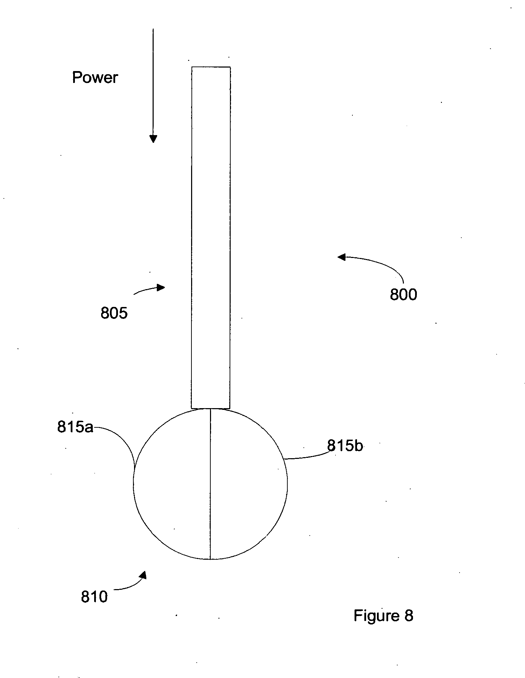

Geometries enabled by the electrode arrangement of the plasma source may be used to provide re-entrant probes such as that shown in Figure 8. In this exemplary embodiment of a re-entrant probe 800, an electrode structure 805 is provided at the end of a wand 810. The wand is used to insert the structure 805 into confined areas so as to enable an application of a plasma coating to internal surfaces for applications such as bottle coatings, treatment of automotive and aeronautical parts and other components that are not suited to conventional plasma applications. In such an RF re-entrant probe, the RF may be provided locally at the electrode structure or could be generated externally to the probe and transmitted down the wand to the structure. Where the structure is provided as a spherical geometry, the electrodes could be arranged for example in the form of two distinct segments 815a, 815b arranged in a hemisphere arrangement or a plurality of a segments arranged about the surface of the sphere, somewhat similar to a dimple arrangement on a golf ball. The description of a re-entrant probe with reference to a spherical geometry is not intended to be limiting in that any re-entrant probe that is implemented with a plurality of electrodes powered at high frequency is intended to be encompassed within the context of the present plasma source.

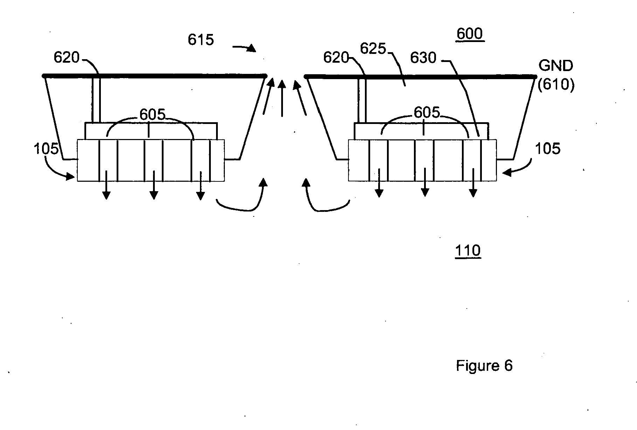

Although the plasma source may be used with known gas distribution feeds such as a shower effect electrode with radial gas flow and pumping on the perimeter of the plasma volume, it also provides in certain embodiments sources that utilise a gas distribution feed that enables the removal of gas away from the lower reference electrode. Figure 6 shows a portion of such a source where two adjacent electrodes that make up the reactive element are illustrated. The electrodes are mounted below a gas feed chamber 600, and the gas that is within this chamber may be introduced firstly to a feed chamber 630 through an entrance conduit 620 and then into the plasma excitation region 110 through a plurality of apertures 605 provided in the electrodes of the type that will be known to those skilled in the art from existing showerhead technology. Once the gas has entered into the excitation region 110 it then flows towards a ground plate 610 providing a gas exit 615 above the electrodes into a pumping plenum 620. The pumping plenum is electrically isolated from the plasma volume thereby obviating the possibility of the plasma reforming in this region. This pumping of the gas away from the excitation region obviates the possibility of the etchant gas interacting with the substrate being treated on the reference electrode. It may be necessary in this arrangement where the gas is moved around the electrodes to coat the electrodes with a dielectric material 625 such as silicon dioxide or the like. Such a dielectric coating is shown as defining the exit path for the gas, but the exact extent of the coating could vary depending on application.

It will be appreciated that what has been described herein is a new plasma source which provides for centre-to-edge power deposition by electrode spacing and/or power distribution design and/or active elements such as capacitors and/or inductors so as to provide for a controlled uniformity profile plasma. In certain applications this can require a difference in the profile of the plasma at certain regions of applications, such that specific selected areas are regions of greater plasma deposition as opposed to other. Other applications may require the same profile across the substrate. Although, the electrodes have been described with regard to exemplary embodiments it will be appreciated that the configuration chosen for a specific application can be such so as to have the electrodes arranged on any arbitrary - shape plasma facing element including for example flat, hemispheric, dome, convex, concave, undulating. The electrodes could be in direct contact with the plasma or could alternatively interact with the plasma through a dielectric window provided from materials such as SiN, AIN, SiC, SiO₂, Si etc.. The arrangement of the plasma source provides a number of distinct advantages including:
Compatible with HF + LF independent control of ion energy (Eᵢₒₙ) and ion flux (┌ᵢₒₙ).
The ability to scan from RF to UHF allows a new dimension in plasma control, namely control of the plasma chemistry independently from the plasma density and ion energy.

As the individual electrodes making up the reactive element may be dimensioned small, and the dimensions of these can define the plasma volume it is possible to provide a plasma source having a small plasma volume. Any individual non-uniform power coupling from an individual electrode or pair of electrodes does not result in non-uniform plasma density at a large enough distance from the electrodes. Specifically, it will be understood that as each of the individual elements are reduced in size that the distance required within the plasma volume for the overall generated plasma to be equalised is reduced.

The source may be used with substrates of many different dimensions as it may be configured to provide minimal centre-to-edge power deposition effects over an extended area and as such is suitable for large substrates (300mm wafers, FPD, textiles and the like). This enables simplified process scaling from one size substrate to another.

Similarly, the possibility of using high frequency sources is advantageous as one can choose the operational frequency to match the process required, and it is possible to go to higher frequencies than heretofore achievable without introducing plasma non-uniformity.

The source may be used with gas distribution feeds similar to present generation systems or alternatively may be used with a distribution feed that minimizes any interaction between etchant or deposition by-product gas and the substrate material.

Reduced system cost as lower electrode can be grounded. This is particularly advantageous in that there is no longer a requirement to provide a high frequency lower plate, which had the requirement that ancillary equipment needed to be isolated from ground, whereas the configuration of the invention enables the ancillary equipment to be grounded.

Compatible with advanced HF power supply technology and direct - drive switch-mode power, which can provide the necessary frequencies at a lower cost. No HF through lower electrode, so variable gap easier to engineer. As the HF component is applied to the reactive elements solely it is possible to minimize the HF return through chamber body, so unconfined plasma should be less likely to occur. Furthermore, there is no longer the requirement to stringently provide for such HF paths in other components of the chamber.

It will be understood that the plasma source provides for plurality of physically individually distinct reactive elements with adjacent electrodes being coupled out of phase with one another. It will be appreciated that if two adjacent electrodes are couple in phase with one another that they in effect resemble a physically larger single electrode, and that such a single larger electrode will be out of phase with its immediate neighbours.

The reactive elements may be provided in any configuration or array structure, for example a 2-D array or linear structure which may, it will be appreciated, be scaled in dimension depending on the application required. It will be appreciated that the configuration of the present plasma source provides for such scaling while maintaining compatibility with VHF/UHF operation requirements and performance levels.

It will be understood that what has been described herein are varying modifications to a plasma source that uses a plurality of electrodes as opposed to a conventional single electrode approach. By implementing such a source it is possible to provide a lower cost per wafer, have higher yields for etch and for chemical vapour deposition (CVD) in semiconductor and flat panel manufacturing processes and is scaleable to larger than 300mm wafers and for use in large format displays. Such advantages and others are possible for a variety of reasons including the fact that there is greater control of the plasma through driver control and through gas pumping arrangements, a reduction in edge effects and by enabling plasma generation using a low plasma volume.

Heretofore the individual electrodes that are described as making up the reactive element have been described with reference to planar or smooth surfaces on the surface of the electrode facing the plasma excitation region. The plasma source also allows for the modification of the topography of such surfaces to include one or more profiles formed on their surfaces, such as for example dimples. The provision of such topography increases the surface area of the surface of that electrode which is in contact with the plasma excitation region. In this way the surface area ratio of the reactive impedance element relative to the workpiece or substrate that is being processed within the chamber can be increased greater than 1 without necessitating a larger number of individual electrodes or increasing the side to side dimensions of the individual electrodes. In this way a differential high frequency, common-mode low frequency source could be provided, where the height-topology of the segmented electrodes means that from a low frequency point of view the area ratio of impedance element to workpiece is not 1. In order to ensure that coupling between adjacent electrodes is controlled it is desirable that the surfaces of each electrode in a region adjacent to that of its neighbour is co-planar with the corresponding region of its neighbour. In this way each electrode surface may have a first planar region, a non-planar region and a second planar region.

It will be understood that the plasma source provides for electrodes forming the reactive impedance element being so arranged that the electromagnetic induced radial fields (parallel to the surface of one electrode) is demonstrably co-planar and in-phase with the electromagnetic radial fields of the neighbouring electrode. Depending on electrode spacing, the two electromagnetic fields may be linked by the electro-static fringe fields between the adjacent electrodes. Then, by controlling the frequency, the power transferred to an adjacent plasma occurs by a frequency-dependent mixture of electrostatic fields perpendicular to the electrode surfaces (low frequency), or electromagnetic (and electrostatic-fringe-fields) fields parallel to the surface (high frequency).

There are a number of different technologies where use of the present plasma source has benefit. These include plasma etch, CVD, and modification. The latter application, modification, is where a processing of a substrate using plasma techniques may be used to effect changes in the surface properties of the substrate. This may be achieved by changing the physical and/or chemical properties of the surface without a (substantial) deposition or removal of material. For example, one can make a surface hydrophobic or hydrophillic simply by changing the dangling bonds on the ends of the lipids - for example making wool absorb water so that water-based dyes can be used. Sometimes modification is called 'functionalizing' and/or `passivating'. Within each of these three technology headings there are a variety of applications that could be suited to the plasma source of the invention. Such applications include plasma etch wafer fabrication equipment, the use of plasma etch in the production discrete display substrates and discrete photovoltaic substrates, plasma etch in the production of roll to roll photovoltaic substrates, CVD used with discrete substrates such as photovoltaic, architectural glass, aerospace coatings, medical devices, automotive applications and CVD used in roll to roll applications for example for use with paper, metals, fabrics and plastics.

Therefore although the plasma source has been described with reference to exemplary illustrative embodiments it will be appreciated that specific components or configurations described with reference to one figure may equally be used where appropriate with the configuration of another figure. Any description of these examples are not intended to limit the plasma source in any way as modifications or alterations can and may be made. It will be understood that the plasma source is not to be limited in any way except as may be deemed necessary in the light of the appended claims.

Similarly, the words comprises/comprising when used in this specification are to specify the presence of stated features, integers, steps or components but does not preclude the presence or addition of one or more other features, integers, steps, components or groups thereof.

## Claims

1. A plasma source (200) having a chamber including a reference electrode (115) and a plasma exciting reactive impedance element (105), the reference electrode and reactive impedance element defining a plasma excitation volume (110) therebetween the source further comprises adjustment means allowing a relative movement of the reference electrode (115) and the reactive impedance element (105) so as to enable a varying of the size of the plasma excitation volume (110); and wherein the plasma excitation reactive impedance element is formed from a plurality of electrodes (105a, 105b, 105c, 105d) being arranged side by side with one another and collectively being located to a first side of the plasma excitation volume (110), the reference electrode (105) being located to a second side of plasma excitation region (110), the plurality of electrodes (105a, 105b, 105c, 105d) forming the reactive impedance element being coupled to a high frequency generator (125) and wherein the plasma source is configured such that, in use, on coupling the electrodes to the high frequency generator, adjacent electrodes of the plurality of electrodes are out of phase with one another and are arranged such that any high frequency current introduced by a first electrode is substantially cancelled by a second electrode, and **characterised in that:**
the source comprises multiple low frequency generators (120) operable in a common mode configuration, the electrodes of the reactive impedance element (1 05a, 105b, 105c, 105d) being additionally coupled to the low frequency generators (120).

2. The source as claimed in any preceding claim wherein the operational frequencies of the high frequency generator (125) are in the range 15MHz to 299GHz optionally in the range 20 MHz to 250 GHz, and further optionally in the range 25 MHz to 150 GHz.

3. The source as claimed in any preceding claim wherein at least one of the electrodes forming the reactive impedance element (105) is provided with a non-planar surface topography so as to increase the contact surface area of that electrode with the plasma excitation region.

4. The source as claimed in any preceding claim wherein the high frequency generator (125) is tuneable from frequencies in a radio frequency range to frequencies in the ultra high frequency range.

5. The source as claimed in any preceding claim wherein a subset of the plurality of electrodes (1 05a, 105b, 105c, 105d) coupled to the low frequency generators (120) are operable in a common mode while others of the plurality of electrodes coupled to the low frequency generators (125) are operable in a differential mode.

6. The source as claimed in any preceding claim wherein the low frequency (120) and high frequency generators (125) are operable simultaneously.

7. The source as claimed in any preceding claim wherein each of the low (120) and high frequency (125) generators are configured such that they can be independently operated of the other of the high frequency (125) or low frequency generators (120) respectively.

8. The sources as claimed in any preceding claim wherein each of the outputs of the low (120) and high frequency (125) generators are configured so as to provide an output controlling a process parameter that is independent of the process parameter controlled by the other of outputs.

9. The source as claimed in any preceding claim wherein the plurality of electrodes (1 05a, 105b, 105c, 105d) forming the reactive impedance element (105) are provided in a planar arrangement, individual electrodes of the reactive impedance element being axially aligned with others of the reactive impedance element.

10. The source as claimed in any one of claims 1 to 9 wherein the plurality of electrodes (105a, 105b, 105c, 105d) forming the reactive impedance element are arranged to provide a curved element so as to enable a processing of planar or non-planar workpieces.

11. The source as claimed in any preceding claim wherein the reactive impedance element is configured to enable a gas feed through a subset of the plurality of electrodes (1 05a, 105b, 105c, 105d).

12. The source as claimed in claim 11 wherein the reactive impedance element is configured to enable a gas feed through all of the electrodes (1 05a, 105b, 105c, 105d).

13. The source as claimed in claim 11 wherein individual electrodes of the reactive impedance element are configured in a showerhead configuration.

14. The source as claimed in claim 11 wherein gas flow through individual electrodes can be controlled separately.

15. The source as claimed in claim 14 wherein a control of the gas flow through individual electrodes provides a multiple zone gas feed, thereby enabling different gas chemistry in different regions of the plasma excitation region.

16. The source as claimed in any preceding claim further including a pump, the pump enabling a pumping between individual electrodes (1 05a, 105b, 105c, 105d) of the reactive impedance element so as to provide for a removal of gas from the plasma excitation region (110).

17. The source as claimed in claim 16 being configured to enable a removal of the gas to a region of the source which is electrically isolated from the plasma excitation region thereby preventing the reforming of a plasma.

18. The source as claimed in any preceding claim wherein the high frequency generator (125) is a dual-phase supply or a tri-phase supply

19. The source as claimed in any preceding claim and arranged such that power is provided in a switch mode configuration which may include sets of electrodes at the same phase all driven by the same switch or for a coupling of each electrode to its own switch or for a coupling of two or more electrodes to a single switch, the switch mode configuration optionally providing a coupling of a low frequency generator to DC feed-lines.

## Patentansprüche

1. Plasmaquelle (200) mit einer Kammer, die eine Bezugselektrode (115) und ein Plasma-anregendes Blindwiderstandselement (105) aufweist, wobei die Bezugselektrode und das Blindwiderstandselement ein Plasmaanregungsvolumen (110) dazwischen definieren, wobei die Quelle ferner ein Einstellmittel aufweist, das eine relative Bewegung der Bezugselektrode (115) und des Blindwiderstandselements (105) erlaubt, so dass die Größe des Plasmaanregungsvolumens (110) variiert werden kann, und wobei das Plasmaanregende Blindwiderstandselement von einer Vielzahl von Elektroden (105a, 105b, 105c, 105d) gebildet wird, die nebeneinander angeordnet sind und die sich gemeinsam auf einer ersten Seite des Plasmaanregungsvolumens (110) befinden, wobei die Bezugselektrode (105) sich auf einer zweiten Seite einer Plasmaanregungsregion (110) befindet, wobei die Vielzahl von Elektroden (105a, 105b, 105c, 105d), die das Blindwiderstandselement bilden, an einen Hochfrequenzgenerator (125) gekoppelt sind, und wobei die Plasmaquelle so gestaltet ist, dass bei ihrer Verwendung bei der Kopplung der Elektroden an den Hochfrequenzgenerator benachbarte Elektroden aus der Vielzahl von Elektroden gegeneinander verschobene Phasen aufweisen und so angeordnet sind, dass ein Hochfrequenzstrom, der von einer ersten Elektrode zugeführt wird, von einer zweiten Elektrode im Wesentlichen kompensiert wird,
**dadurch gekennzeichnet, dass:**
die Quelle mehrere Niederfrequenzgeneratoren (120) aufweist, die in einer Gleichtaktkonfiguration betätigt werden können, wobei die Elektroden des Blindwiderstandselements (105a, 105b, 105c, 105d) auch mit den Niederfrequenzgeneratoren (120) gekoppelt sind.

2. Quelle nach einem der vorangehenden Ansprüche, wobei die Betriebsfrequenzen des Hochfrequenzgenerators (125) im Bereich von 15 MHz bis 299 GHz, bevorzugt im Bereich von 20 MHz bis 250 GHz, und noch stärker bevorzugt im Bereich von 25 MHz bis 150 GHz liegen.

3. Quelle nach einem der vorangehenden Ansprüche, wobei mindestens eine der Elektroden, die das Blindwiderstandselement (105) bilden, eine nicht-planare Oberflächentopographie aufweist, um die Kontaktfläche dieser Elektrode mit der Plasmaanregungsregion zu vergrößern.

4. Quelle nach einem der vorangehenden Ansprüche, wobei der Hochfrequenzgenerator (125) von Frequenzen in einem Hochfrequenzbereich bis zu Frequenzen im Ultrahochfrequenzbereich durchgestimmt werden kann.

5. Quelle nach einem der vorangehenden Ansprüche, wobei eine Untergruppe der Vielzahl von Elektroden (105a, 105b, 105c, 105d), die mit den Niederfrequenzgeneratoren (120) gekoppelt sind, im Gleichtaktmodus betätigt werden kann, während andere von der Vielzahl von Elektroden, die mit den Niederfrequenzgeneratoren (125) gekoppelt sind, in einem Gegentaktbetrieb betreibbar sind.

6. Quelle nach einem der vorangehenden Ansprüche, wobei die Niederfrequenz-(120) und Hochfrequenzgeneratoren (125) gleichzeitig betätigt werden können.

7. Quelle nach einem der vorangehenden Ansprüche, wobei jeder von den Niederfrequenz- (120) und Hochfrequenzgeneratoren so konfiguriert ist, dass er jeweils unabhängig von den anderen Hochfrequenz- (125) oder Niederfrequenzgeneratoren (120) betreibbar sind.

8. Quellen nach einem der vorangehenden Ansprüche, wobei jeder der Ausgänge der Nieder- (120) und Hochfrequenzgeneratoren (125) so konfiguriert ist, dass eine Ausgabe bereitgestellt wird, die einen Prozessparameter steuert, der unabhängig ist von dem von den anderen Ausgängen gesteuerten Prozessparameter.

9. Quelle nach einem der vorangehenden Ansprüche, wobei die Vielzahl von Elektroden (105a, 105b, 105c, 105d), die das Blindwiderstandselement (105) bilden, in einer planaren Anordnung vorgesehen sind, wobei individuelle Elektroden des Blindwiderstandselements mit anderen Blindwiderstandselementen axial ausrichtet sind.

10. Quelle nach einem der vorangehenden Ansprüche 1 bis 9, wobei die Vielzahl von Elektroden (105a, 105b, 105c, 105d), die das Blindwiderstandselement bilden, so angeordnet sind, dass sie ein gekrümmtes Element ergeben, um eine Bearbeitung von planen und nicht-planen Werkstücken zu ermöglichen.

11. Quelle nach einem der vorangehenden Ansprüche, wobei das Blindwiderstandselement so konfiguriert ist, dass eine Gaseinspeisung durch eine Untergruppe der Vielzahl von Elektroden (105a, 105b, 105c, 105d) möglich ist.

12. Quelle nach Anspruch 11, wobei das Blindwiderstandselement so konfiguriert ist, dass eine Gaseinspeisung durch alle Elektroden (105a, 105b, 105c, 105d) möglich ist.

13. Quelle nach Anspruch 11, wobei einzelne Elektroden des Blindwiderstandselements als Showerhead-Konfiguration ausgebildet sind.

14. Quelle nach Anspruch 11, wobei ein Gasstrom durch einzelne Elektroden separat gesteuert werden kann.

15. Quelle nach Anspruch 14, wobei eine Steuerung des Gasstroms durch einzelne Elektroden eine Mehrzonen-Gaseinspeisung ergibt, wodurch unterschiedliche Gaschemie in unterschiedlichen Regionen der Plasmaanregungsregion möglich ist.

16. Quelle nach einem der vorangehenden Ansprüche, ferner eine Pumpe aufweisend, wobei die Pumpe ein Pumpen zwischen einzelnen Elektroden (105a, 105b, 105c, 105d) des Blindwiderstandselements möglich macht, um für eine Abführung von Gas aus der Plasmaanregungsregion (110) zu sorgen.

17. Quelle nach Anspruch 16, die so konfiguriert ist, dass eine Abführung von Gas in eine Region der Quelle, die elektrisch gegenüber der Plasmaanregungsregion isoliert ist, möglich ist, um dadurch die Neubildung von Plasma zu verhindern.

18. Quelle nach einem der vorangehenden Ansprüche, wobei der Hochfrequenzgenerator (125) eine Zweiphasen-Zufuhr oder eine Dreiphasen-Zufuhr darstellt.

19. Quelle nach einem der vorangehenden Ansprüche, die außerdem so angeordnet ist, dass Leistung in einer Schaltmoduskonfiguration ausgegeben wird, die beinhalten kann, dass Gruppen von gleichphasigen Elektroden alle vom gleichen Schalter angesteuert werden, oder dass jede Elektrode mit einem eigenen Schalter gekoppelt ist, oder dass zwei oder mehr Elektroden mit einem einzigen Schalter gekoppelt sind, wobei die Schaltmoduskonfiguration optional eine Kupplung eines Niederfrequenzgenerators mit Gleichstromzuleitungen ermöglicht.

## Revendications

1. Source à plasma (200) comportant une chambre comprenant une électrode de référence (115) et un élément à impédance réactive (105) d'excitation du plasma, l'électrode de référence et l'élément à impédance réactive définissant entre eux un volume d'excitation (110) du plasma, la source comprenant, en outre, des moyens de réglage permettant un mouvement relatif de l'électrode de référence (115) et de l'élément à impédance réactive (105) afin de permettre une variation de la dimension du volume d'excitation (110) du plasma et l'élément à impédance réactive d'excitation du plasma étant formé à partir d'une pluralité d'électrodes (105a, 105b, 105c, 105d) agencées les unes à côté des autres et collectivement situées sur un premier côté du volume d'excitation (110) du plasma, l'électrode de référence (105) étant située sur un second côté de la région d'excitation (110) du plasma, la pluralité d'électrodes (105a, 105b, 105c, 105d) formant l'élément à impédance réactive étant couplée à un générateur haute fréquence (125) et la source à plasma étant configurée de façon telle qu'en cours d'utilisation, lors du couplage des électrodes au générateur haute fréquence, des électrodes adjacentes de la pluralité d'électrodes sont déphasées entre elles et sont agencées de sorte que n'importe quel courant haute fréquence introduit par une première électrode est sensiblement annulé par une seconde électrode, et
**caractérisée en ce que**
la source comprend des générateurs à basses fréquences multiples (120) aptes à fonctionner dans une configuration de mode commun, les électrodes de l'élément à impédance réactive (105a, 105b, 105c, 105d) étant couplées, en outre, aux générateurs basse fréquence (120).

2. Source selon l'une quelconque des revendications précédentes, dans laquelle les fréquences opérationnelles du générateur haute fréquence (125) sont dans la plage de 15 MHz à 299GHz, éventuellement dans la plage de 20 MHz à 250 GHz, et en outre, éventuellement dans la plage de 25 MHz à 150 GHz.

3. Source selon l'une quelconque des revendications précédentes, dans laquelle au moins l'une des électrodes formant l'élément à impédance réactive (105) est pourvue d'une topographie de surface non planaire afin d'augmenter la surface de contact de cette électrode avec la région d'excitation du plasma.

4. Source selon l'une quelconque des revendications précédentes, dans laquelle le générateur haute fréquence (125) est syntonisable depuis des fréquences dans un domaine de radiofréquences jusqu'à des fréquences dans le domaine des ultra-hautes fréquences.

5. Source selon l'une quelconque des revendications précédentes, dans laquelle un sous-ensemble de la pluralité d'électrodes (105a, 105b, 105c, 105d) couplées aux générateurs basse fréquence (120) sont aptes à fonctionner en mode commun tandis que d'autres de la pluralité d'électrodes couplées aux générateurs basse fréquence (125) sont aptes à fonctionner dans un mode différentiel.

6. Source selon l'une quelconque des revendications précédentes, dans laquelle générateurs basse fréquence (120) et haute fréquence (125) sont aptes à fonctionner simultanément.

7. Source selon l'une quelconque des revendications précédentes, dans laquelle chacun des générateurs basse fréquence (120) et haute fréquence (125) est configuré de manière à pouvoir fonctionner indépendamment de l'autre, respectivement, des générateurs haute fréquence (125) et basse fréquence (120).

8. Source selon l'une quelconque des revendications précédentes, dans laquelle chacune des sorties des générateurs basse fréquence (120) et haute fréquence (125) est configurée pour fournir une sortie qui commande un paramètre de traitement qui est indépendant du paramètre de traitement commandé par l'autre des sorties.

9. Source selon l'une quelconque des revendications précédentes, dans laquelle la pluralité d'électrodes (105a, 105b, 105c, 105d) formant l'élément à impédance réactive (105) est prévue selon un agencement planaire, des électrodes individuelles de l'élément à impédance réactive étant axialement alignées avec d'autres de l'élément à impédance réactive.

10. Source selon l'une quelconque des revendications 1 à 9, dans laquelle la pluralité d'électrodes (105a, 105b, 105c, 105d) formant l'élément à impédance réactive est agencée pour fournir un élément incurvé afin de permettre un traitement de pièces à travailler planaires ou non planaires.

11. Source selon l'une quelconque des revendications précédentes, dans laquelle l'élément à impédance réactive est configuré pour permettre une alimentation en gaz au travers d'un sous-ensemble de la pluralité d'électrodes (105a, 105b, 105c, 105d).

12. Source selon la revendication 11, dans laquelle l'élément à impédance réactive est configuré pour permettre une alimentation en gaz à travers toutes les électrodes (105a, 105b, 105c, 105d).

13. Source selon la revendication 11, dans laquelle des électrodes individuelles de l'élément à impédance réactive sont conçues selon une configuration en pomme de douche.

14. Source selon la revendication 11, dans laquelle l'écoulement de gaz à travers des électrodes individuelles peut être commandé séparément.

15. Source selon la revendication 14, dans laquelle une commande de l'écoulement de gaz à travers des électrodes individuelles fournit une alimentation en gaz à zones multiples, permettant différentes propriétés chimiques du gaz dans différentes régions de la région d'excitation du plasma.

16. Source selon l'une quelconque des revendications précédentes, comprenant, en outre, une pompe, la pompe permettant un pompage entre des électrodes individuelles (105a, 105b, 105c, 105d) de l'élément à impédance réactive afin d'assurer une extraction de gaz de la région d'excitation (110) du plasma.

17. Source selon la revendication 16, configurée pour permettre une extraction du gaz vers une région de la source qui est électriquement isolée de la région d'excitation du plasma, évitant ainsi le reformage d'un plasma.

18. Source selon l'une quelconque des revendications précédentes, dans laquelle le générateur haute fréquence (125) est une alimentation biphasée ou une alimentation triphasée.

19. Source selon l'une quelconque des revendications précédentes, agencée de façon telle que la puissance est fournie dans une configuration en mode commutation qui peut comporter des ensembles d'électrodes à la même phase, toutes attaquées par le même commutateur ou pour un couplage de chaque électrode à son propre commutateur ou pour un couplage de deux électrodes ou plus à un commutateur unique, la configuration en mode commutation assurant éventuellement un couplage d'un générateur basse fréquence à des lignes d'alimentation à courant continu.
